# EUROPEAN PATENT APPLICATION

(11) **EP 2 814 303 A1**
(43) Date of publication of application: **17.12.2014**
(21) Application number: 12867742.4
(22) Date of filing: 27.07.2012
(51) Int. Cl.: H05B 33/26, H01L 51/42, H01L 51/50, H01M 4/64, H01M 4/66, H01M 14/00, H05B 33/14

(54) **ELECTRODE FOIL AND ELECTRONIC DEVICE**

(30) Priority: 07.02.2012 JP 2012023794
(71) Applicant: Mitsui Mining and Smelting Co., Ltd., Shinagawa-ku Tokyo 141-8584 (JP)
(72) Inventor: MATSUURA Yoshinori, Tokyo 141-8584 (JP); KITAJIMA Nozomu, Tokyo 141-8584 (JP); NAKAMURA Toshimi, Tokyo 141-8584 (JP); MYOI Masaharu, Tokyo 141-8584 (JP)
(74) Representative: Potter Clarkson LLP
(86) International application number: PCT/JP2012/069230
(87) International publication number: WO 2013/118325

(57) **Abstract**

An electrode foil functioning as both a supporting substrate and an electrode and suitable for low-cost high-efficiency production of flexible electronic devices having functionality on their both sides is provided. An electrode foil of the present invention comprises a metal foil, wherein the metal foil has a thickness of 1 to 250 µm, and wherein the outermost surfaces on both sides of the electrode foil are ultra-smooth surfaces each having an arithmetic mean roughness Ra of 30.0 nm or less as determined in accordance with JIS B 0601-2001.

## Description

### CROSS-REFERENCE TO RELATED APPLICATION

This application claims priority to Japanese Patent Application No. 2012-23794 filed on February 7, 2012, the entire disclosure of which is incorporated herein by reference.

### TECHNICAL FIELD

The present invention relates to an electrode foil including a metal foil; and an electronic device including the electrode foil, such as a light-emitting element, a photoelectric element, and a thermoelectric element; and more specifically, an electrode foil suitable for a double-sided functional element which is provided with electronic devices on both sides.

### BACKGROUND ART

Organic EL lighting devices have recently attracted attention as eco-friendly green devices. The organic EL lighting devices are characterized by 1) lower power consumption than incandescent lamps; 2) thin profile and light weight; and 3) flexibility. The organic EL lighting devices are now being developed to achieve the features 2) and 3). In this respect, glass substrates conventionally used in flat panel displays (FPD) cannot achieve the features 2) and 3).

In this regard, researches have been conducted on a substrate as a support (hereinafter, referred to as "supporting substrate") for organic EL lighting devices, and ultra-thin glass plates, resin films, and metal foils have been proposed as candidate supporting substrates. The ultra-thin glass is superior in heat resistance, barrier performance, and optical transparency and has good flexibility, but is somewhat inferior in handling and has low thermal conductivity and high material cost. The resin film is superior in handling and flexibility and has low material cost and good optical transparency, but is inferior in heat resistance and barrier performance and has low thermal conductivity.

In contrast, the metal foil has excellent characteristics such as superior heat resistance, barrier performance, handling, and thermal conductivity, good flexibility, and low material cost, except for absence of optical transparency. In particular, a typical flexible glass or film has a significantly low thermal conductivity of 1 W/m°C or lower, while a copper foil has a significantly high thermal conductivity of about 280 W/m°C. However, in order to use the metal foil as a supporting substrate for flexible electronic devices, its surface needs to be covered with an insulating film. PTL 1 and PTL 2 propose use of a metal foil, which can function as both a supporting substrate and an electrode.

In the meantime, organic or inorganic EL elements having a light-emitting function on both sides have been studied (e.g., refer to NPL 1 and NPL 2). Such double-sided light-emitting elements, which theoretically can emit light in all directions, are believed to be suitable for lighting applications, but have not yet been practically utilized. One reason precluding the practical use is difficulty in mass production due to its complicated process involving additional formation of electrodes on both sides of the target substrate of a resin or glass.

### CITATION LIST

### [Patent Literature]

PTL 1: WO2001/152091
PTL 2: WO2011/152092

### [Non-Patent Literature]

NPL 1: Sato Toshifumi et al. "Ryomen Hakko Bunsangata Muki EL Hakko Paneru no Denki Tokusei (Electrical Characteristics of Double-sided Dispersive Inorganic Electroluminescent Panel)", Journal of Printing Science and Technology, 43(6), 436-440, 2006-12-31
NPL 2: Tsugita Kohei et al. "Ryomen Hakkogata OLED niokeru Tomei Denkyoku Supatta Damejji Hassei Kikou no Kaiseki to Yokusei (Kinousei Yuuki Hakumaku, ippan) ("Analysis of Mechanism and Elimination of Sputtering Damage Generation of Transparent Electrode in Double-sided OLED (Functional Organic Thin Films, general))", Technical Report of the Institute of Electronics, Information and Communication Engineers (IEICE), OME, Organic Electronics, 103(441), 55-59, 2003-11-12

### SUMMARY OF INVENTION

The inventors have found that a metal foil having significantly planarized surfaces can be used as an electrode foil functioning as both a supporting substrate and an electrode and suitable for low-cost high-efficiency production of flexible electronic devices having functionality on their both sides.

Accordingly, it is an object of the present invention to provide an electrode foil functioning as both a supporting substrate and an electrode and suitable for low-cost high-efficiency production of an electronic device having functionality on their both sides.

According to an aspect of the present invention, there is provided an electrode foil comprising a metal foil, wherein the metal foil has a thickness of 1 to 250 µm, and wherein the outermost surfaces on both sides of the electrode foil are ultra-smooth surfaces each having an arithmetic mean roughness Ra of 30.0 nm or less as determined in accordance with JIS B 0601-2001.

According to another aspect of the present invention, there is provided an electronic device comprising the electrode foil and at least one semiconductor functional layer having semiconductor characteristics provided directly on at least one outermost surface of the electrode foil.

### BRIEF DESCRIPTION OF DRAWINGS

Fig. 1 is a schematic cross-sectional view illustrating an electrode foil of the present invention.
Fig. 2 is a schematic cross-sectional view illustrating a double-sided organic EL element including an anode of the electrode foil of the present invention.
Fig. 3 is a schematic cross-sectional view illustrating a double-sided top-emission organic EL lighting device of the present invention.
Fig. 4 is a schematic cross-sectional view illustrating a double-sided organic EL element including a cathode of the electrode foil of the present invention.
Fig. 5 is a schematic cross-sectional view illustrating a double-sided photoelectric element including an electrode of the electrode foil of the present invention.
Fig. 6 is a schematic cross-sectional view illustrating a double-sided thermoelectric element including an electrode of the electrode foil of the present invention.
Fig. 7 is a schematic cross-sectional view illustrating a hybrid electrooptic and optoelectric element including an electrode of the electrode foil of the present invention.
Fig. 8 is a schematic cross-sectional view illustrating a double-sided photoelectric element prepared in Example 4.

### DESCRIPTION OF EMBODIMENT

### Electrode foil

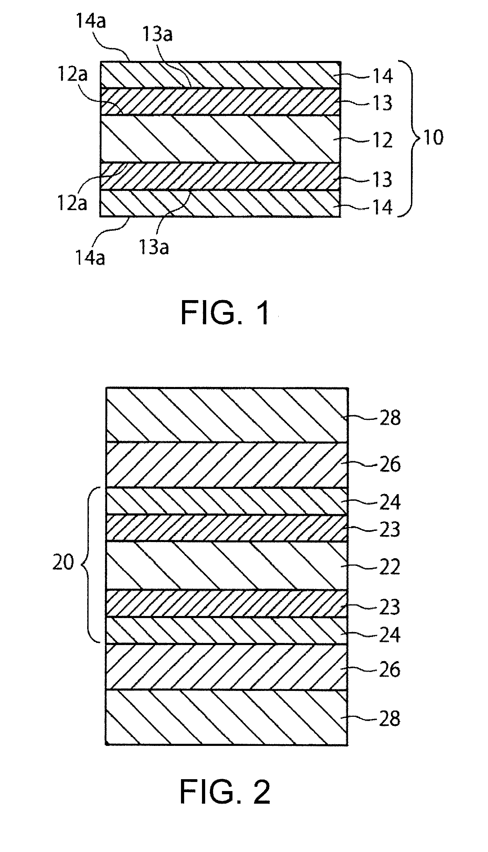

Fig. 1 shows a schematic cross-sectional view of an electrode foil of the present invention. The electrode foil 10 depicted in Fig. 1 includes a metal foil 12 having a thickness of 1 to 250 µm. The electrode foil 10 may optionally include one or two reflective layers 13 provided directly on one or two surfaces of the metal foil 12. The electrode foil 10 may further include one or more optional buffer layer 14 provided directly on one or two surfaces of the metal foil 12, or on one or more outer surfaces of the reflective layers 13, if present. Although the electrode foil 10 depicted in Fig. 1 is a quintuple-layer structure composed of the metal foil 12, the reflective layers 13,13, and the buffer layers 14,14, the electrode foil of the present invention may be any multi-layer structure such as a single-layer structure of a metal foil 12, or a triple-layer structure composed of a metal foil 12 and reflective layers 13,13 or a metal layer 12 and buffer layers 14,14. Alternatively, a reflective layer 13 and/or a buffer layer 14 may be provided on only one side of the metal foil 12, or the layer structure of one side may be different from that of the other side. That is, in the electrode foil of the present invention, these layer structures on both sides of the electrode foil 10 can be individually determined appropriately depending on functions or characteristics desired for each side of the double-sided functional element.

The outermost surfaces on both sides of the electrode foil 12 are ultra-smooth surfaces each having an arithmetic mean roughness Ra of 30.0 nm or less as determined in accordance with JIS B 0601-2001. Such an extreme reduction in the roughness of the outermost surfaces on both sides of the electrode foil 12 allows functional layers (typically semiconductor functional layers) for the electronic devices to be formed on the both sides of the electrode foil 12, achieving a double-sided functional element or a double-sided functional element foil, which provides light emission in all directions in a light-emitting element and a higher voltage in a thermoelectric element and a photoelectric element. An element having a front side and back side (e.g., an indoor side and outdoor side) that have different functions can also be fabricated.

In the present invention, use of the metal foil 12 as a supporting substrate and an electrode provides an electrode foil which functions as both a supporting substrate and an electrode. Furthermore, the metal foil 12 having a thickness of 1 to 250 µm can be used as an electrode functioning as a supporting substrate for a flexible electronic device. In production of such a flexible electronic device, the electrode foil 12 of the present invention can be manufactured efficiently, for example, by a roll-to-roll process without a particular supporting substrate because the electrode foil 12 is based on a metal foil. The roll-to-roll process is a significantly advantageous process in terms of efficient mass production of electronic devices, in which a long foil is wound off a roll, subjected to a predetermined process and rewound; therefore the roll-to-roll process is a key process to achieve mass production of electronic devices such as a light-emitting element, a photoelectric element, and a thermoelectric element, which belong to the application field of the present invention. Thus, the electrode foil of the present invention does not require a supporting substrate or a reflecting layer. The electrode foil of the present invention, therefore, has no insulating layer at least on a portion where the electronic device is to be disposed, and preferably no insulating layers on any portion.

In particular, the double-sided light-emitting element of the present invention can include a metal foil functioning as both an electrode and a supporting substrate, instead of a conventionally studied glass or resin substrate. The metal foil has several advantages: 1) high conductivity suitable for an electrode, 2) two functions of an electrode and a supporting substrate which eliminate the process for forming electrodes on both sides, leading to a significantly simplified manufacturing process, which contributes to mass production, and 3) high thermal conductivity which improves the reliability and durability of the electronic devices formed of the foil. The advantage 2) significantly improves the productivity of advanced double-sided functional foils in combination with continuous production by a roll-to-roll process as described above. Meanwhile, most of the commercially available metal foils have an arithmetic mean roughness Ra of 0.1 µm or more and thus electronic devices formed thereon will cause a short circuit to the counter electrodes.

Any foil metallic material having a strength and electrical properties required for both a supporting substrate and an electrode, respectively, can be used for the metal foil 12. A preferred metal foil is a nonmagnetic metal foil from the view point of preventing magnetic attraction of particles produced during machining. Examples of the nonmagnetic metal preferably include copper, aluminum, nonmagnetic stainless steel, titanium, tantalum, and molybdenum, and more preferably copper, aluminum, and nonmagnetic stainless steel. The most preferred metal foil is copper foil. Copper foil is relatively inexpensive as well as excellent in strength, flexibility, and electrical properties.

The outermost surfaces on both sides of the electrode foil 10 are ultra-smooth surfaces having an arithmetic mean roughness Ra of 30.0 nm or less, preferably 20.0 nm or less, more preferably 10.0 nm or less, still more preferably 7.0 nm or less, and specially preferably 5.0 nm or less, 3.0 nm or less, 2.8 nm or less, 2.5 nm or less, or 2.0 nm or less, and the appropriate roughness can be determined according to the applications or characteristics required for the electrode foil. The arithmetic mean roughness Ra may have any lower limit; it may be 0 (zero), or 0.5 nm in view of the efficiency of surface smoothing treatment. The arithmetic mean roughness Ra can be determined in accordance with JIS B 0601-2001 with a commercially available surface roughness meter.

The expression "the outermost surfaces on both sides of the electrode foil 10" refers to the surfaces on both sides of the metal foil 12 in the case of a single-layer structure; or the outermost surfaces of the metal foil 12, the reflective layer 13 or the buffer layer 14 whichever is located outermost on each side in the case of a multi-layer structure further having the reflective layer 13 or the buffer layer 14. In the case of such a multi-layer structure, the targeted arithmetic roughness Ra can be achieved by forming the reflective layer 13 and/or the buffer layer 14 on the surface 12a of the metal foil 12 which has an arithmetic mean roughness Ra in a range similar to those mentioned above, namely, 30.0 nm or less, preferably 20.0 nm or less, more preferably 10.0 nm or less, still more preferably 7.0 nm or less, particularly preferably 5.0 nm or less, 3.0 nm or less, 2.8 nm or less, 2.5 nm or less, 2.0 nm or less, or 1.5 nm or less. As described above, it is preferred that the surface of a layer or foil underneath the outermost surface has an arithmetic mean roughness Ra equivalent to or slightly smaller than a targeted arithmetic mean roughness Ra of the outermost surface. The arithmetic mean roughness Ra of the metal foil surface not constituting the outermost surface in the laminate may be evaluated by forming a cross section from the metal foil surface by a focused ion beam (FIB) process; and observing the cross section with a transmission electron microscope (TEM). The arithmetic mean roughness Ra of the reflective layer surface not constituting the outermost surface in the laminate may be evaluated in the same way.

To the best of the inventors' knowledge, a metal foil (particularly, a copper foil) having the aforementioned ultra-smooth surfaces on both sides has not been produced in industrial scale to date, nor has been attempted to be applied to an electrode of flexible electronic devices. A copper foil with smoothed surfaces is commercially available, but such a surface smoothness level of the copper foil is not sufficient for organic EL element electrodes, so that an organic EL element formed of the foil may result in short circuit due to the unevenness and thus fails to provide luminescence.

In contrast, the significantly small arithmetic mean roughness Ra of the ultra-smooth surface 12a of the metal foil 12 as described above can effectively prevent short circuit between the foil and a counter electrode or any other part, even if the foil is used as an electrode for electronic devices such as an organic EL element. Such an ultra-smooth surface can be achieved by polishing the metal foil by chemical mechanical polishing (CMP) treatment. CMP treatment can be performed with a known polishing solution and a known polishing pad under known conditions. The CMP treatment can be conducted on both sides of the metal foil 12 either simultaneously or separately. A preferred polishing solution comprises one or more granular polishing agents selected from ceria, silica, alumina, and zirconia in an amount of from about 0.5 to about 2 wt%; a rust inhibitor such as benzotriazole (BTA); and/or an organic complex forming agent such as quinaldic acid, quinolinic acid, or nicotinic acid; a surfactant such as a cationic surfactant or an anionic surfactant; and optionally an anticorrosive agent. A preferred polishing pad is composed of polyurethane. Adequately regulated polishing conditions such as pad rotational rate, work load, and coating flow of polishing solution can be adopted without particular limitations. It is preferred that the rotational rate be controlled within the range of from 20 rpm to 1,000 rpm, that the work load be controlled within the range of from 100 gf/cm² to 500 gf/cm², and that a coating flow of the polishing solution be controlled within the range of from 20 cc/min to 200 cc/min.

The ultra-smooth surface 12a can be formed by polishing metal foil 12 by electrolytic polishing, buff polishing, chemical polishing, or a combination thereof. Also in this case, the surfaces of both sides of the metal foil 12 can also be polished either simultaneously or separately. The chemical polishing can be carried out without particular limitation under appropriately controlled conditions, for example, the type of a chemical polishing solution, the temperature of the chemical polishing solution, the dipping time in the chemical polishing solution. For example, a mixture of 2-aminoethanol and ammonium chloride can be used for chemical polishing of copper foil. The temperature of the chemical polishing solution is preferably room temperature, and a dipping method (Dip process) is preferably used. Furthermore, the preferred dipping time in the chemical polishing solution ranges from 10 to 120 seconds, more preferably from 30 to 90 seconds since long dipping time often results in loss of the smoothness. The metal foil after chemical polishing is preferred to be washed with running water. Such smoothing treatment can smooth the surface from an original arithmetic mean roughness Ra of about 12 nm to a final roughness of 10.0 nm or less, for example, about 3.0 nm.

The ultra-smooth surface 12a can also be achieved by polishing the surface of the metal foil 12 by blasting; or melting the surface of the metal foil 12 by a technique such as laser, resistance heating, or lamp heating followed by rapid-quenching. Also in this case, the surfaces of both sides of the metal foil 12 can be polished either simultaneously or separately.

The metal foil 12 may have any thickness which allows the metal foil to retain sufficient flexibility and be handled alone as a foil. The thickness of the metal foil 12 may be in the range of from 1 µm to 250 µm, preferably from 5 µm to 200 µm, more preferably from 10 µm to 150 µm, and most preferably from 15 µm to 100 µm and may be appropriately determined according to the applications or the characteristics required for the electrode foil. If further reductions in the amount and weight are required, the upper limit of the thickness is preferably 50 µm, 35 µm, or 25 µm. If further strength is required, the lower limit of the thickness is preferably 25 µm, 35 µm, or 50 µm. A metal foil with such a thickness can be cut readily with a commercially available cutting machine. Unlike glass substrates, the metal foil 12 does not have disadvantages such as cracking and chipping, but has an advantage of not easily generating particulate matter during cutting. The metal foil 12 may be formed into various shapes, such as circle, triangle, and polygon, other than tetragon, and can also be cut and pasted to fabricate electronic devices with a three-dimensional shape, such as a cubic shape or a spherical shape since the metal foil can be cut and welded. In this case, it is preferred that a semiconductor functional layer be not formed at a cutting or welding portion of the metal foil 12.

The ultra-smooth surface 12a is preferably washed with an alkaline solution. A known alkaline solution, such as an ammonia-containing solution, a sodium hydroxide solution, and a potassium hydroxide solution can be used. The alkaline solution is preferably an ammonia-containing solution, more preferably an organic alkaline solution containing ammonia, most preferably a tetramethylammonium hydroxide (TMAH) solution. The preferred concentration of the TMAH solution ranges from 0.1 wt% to 3.0 wt%. An example of the washing described above involves washing at 23°C for one minute with a 0.4 % TMAH solution. A similar washing effect can also be attained by UV (Ultra Violet) treatment in combination with or in place of the washing with the alkaline solution. Furthermore, oxides formed on the surface of, for example, copper foil can be removed with an acidic washing solution such as dilute acid. An example of the acid washing involves washing for 30 seconds with dilute sulfuric acid.

Particles on the ultra-smooth surface 12a should preferably be removed. Examples of effective removal techniques of particles include sonic washing with ultra-pure water and dry-ice blasting. Dry-ice blasting is more effective. The dry-ice blasting involves ejecting highly compressed carbon dioxide gas through a fine nozzle and thereby squirting the ultra-smooth surface 12a with carbon dioxide solidified at low temperature to remove the particles. Unlike wet processes, the dry-ice blasting has advantages of no drying process and readily removable organic substances. The dry-ice blasting can be performed with a commercially available apparatus, such as a dry-ice snow system (manufactured by AIR WATER INC.).

The reflective layer 13 may be optionally provided directly on the ultra-smooth surface of the metal foil 12. The reflective layer 13 is preferably composed of at least one metal or alloy selected from the group consisting of aluminum, aluminum alloys, silver, and silver alloys. These materials are suitable for a reflective layer due to high optical reflectivity and thin films formed thereof also have excellent smoothness. In particular, inexpensive aluminum and aluminum alloys are preferred. A wide variety of aluminum alloys and silver alloys having conventional alloy compositions can be used as an anode or a cathode of display devices such as organic EL elements. Preferred examples of the aluminum alloy compositions include Al-Ni; Al-Cu; Al-Ag; Al-Ce; Al-Zn; Al-B; Al-Ta; Al-Nd; Al-Si; Al-La; Al-Co; Al-Ge; Al-Fe; Al-Li; Al-Mg; and Al-Mn. Any element that constitutes these alloys may be combined thereof, depending on required characteristics. Preferred examples of the silver alloy compositions include Ag-Pd; Ag-Cu; Ag-Al; Ag-Zn; Ag-Mg; Ag-Mn; Ag-Cr; Ag-Ti; Ag-Ta; Ag-Co; Ag-Si; Ag-Ge; Ag-Li; Ag-B; Ag-Pt; Ag-Fe; Ag-Nd; Ag-La; and Ag-Ce. Any element that constitutes these alloys may be combined thereof, depending on required characteristics. The reflective layer 13 can have any thickness; and preferably has 30 nm to 500 nm, more preferably 50 nm to 300 nm, and most preferably 100 nm to 250 nm.

The surface 13a of the reflective layer 13 can have an arithmetic mean roughness Ra of 30.0 nm or less, preferably 20.0 nm or less, more preferably 10.0 nm or less, still preferably 7.0 nm or less, and particularly preferably 5.0 nm or less, 3.0 nm or less, 2.8 nm or less, 2.5 nm or less, or 2.0 nm or less. As described above, in the electrode foil of the present invention, the reflective layer formed on the ultra-smoothness of the surface of the metal foil can also has a highly smooth surface having a small arithmetic mean roughness Ra. This can reduce the risk of short circuit between the semiconductor functional layers such as the organic EL layers, which is caused by occurrence of excess unevenness. Since the hole injection layer and the hole transport layer or the electron injection layer and the electron transport layer may be thin in organic EL elements without being affected by the surface unevenness of the reflective layer, these layers and a semiconductor functional layer including these layers can be made thinner than conventional thicknesses. As a result, the usage of significantly expensive organic raw materials can be reduced, thereby achieving lower production costs and increased light-emitting efficiency due to the thinned organic EL layer. Such advantages derived from thinned layers in the organic EL element can also be similarly applied to electronic devices in general.

The reflective layer 13, in the case of being composed of an aluminum film or an aluminum alloy film, can have a laminate structure including at least two layers. In the above embodiment, the reflective layer 13 has a laminate structure of two layers which are separated from each other by an interface, across which the lower layer and the upper layer have different crystal orientations. Thus, even if the electrode foil is exposed to a considerably high temperature, thermal migration that may occur from the interface between the copper foil and the aluminum-containing reflective layer can be effectively reduced to prevent deterioration of the surface smoothness and optical reflectivity caused by the thermal migration. That is, the heat resistance of the electrode foil can be improved. Accordingly, the above embodiment is particularly effective in heat treatment which is performed at a temperature of 200°C or higher, preferably 230°C or higher, and more preferably 250°C or higher after the hole injection layer is coated. The improved heat resistance is probably due to blocking the thermal migration preferential in crystal boundaries by the interfaces where the crystal boundaries discontinue. The number of the interfaces in the reflective layer 13 may be two or more, which means that the reflective layer is a laminate structure of three or more layers.

The reflective layer of the laminate structure may be prepared through a film-forming process such as multiple cycles of sputtering at predetermined intervals. Preferred examples of such a process are as follows:
(1) A lower layer is formed by sputtering into a thickness of preferably 10 nm or more, and then the sputtering is temporarily stopped. The lower layer is left as it is in a chamber of a sputtering apparatus. The standing time in the chamber is preferably 30 seconds or more. The sputtering is then restarted to form an upper layer.
(2) A lower layer is formed by sputtering into a thickness of preferably 10 nm or more, and then the sputtering is temporarily stopped. The lower layer is then contacted with air. The contact with air may involve removing the metal foil provided with the lower layer from the chamber of the sputtering apparatus to expose it to air or venting the chamber to air without removal of the metal foil therefrom. Sputtering is then restarted to form the upper layer. Exposure of the lower layer to air for several seconds is enough to achieve a desired effect at a temperature and humidity as provided in conventional clean room atmospheres.
(3) A lower layer is formed by sputtering into a thickness of preferably 10 nm or more, and then the sputtering is temporarily stopped. The chamber of the sputtering apparatus is charged with an oxygen atmosphere. The evacuation is then restarted, and the upper layer is formed. The pressure in the chamber charged with oxygen is preferably 0.01 Pa or more, more preferably 0.1 Pa or more, and most preferably 1 Pa or more.

Only one interface is sufficient for the reflective layer of the laminate structure since even one interface exhibits sufficient heat resistance at a high temperature of about 250 °C. Two or more interfaces may be provided by increased number of the film forming process to further improve heat resistance.

The buffer layer 14 may be provided directly on the reflective layer 13. In the organic EL element, the buffer layer 14 can be any layer that can come in good contact with an organic EL layer to improve hole injection efficiency or electron injection efficiency and provide a desired work function. Furthermore, electronic devices other than the organic EL element can be also provided appropriately with a buffer layer in order to satisfy desired applications or performances. The buffer layer in the present invention is preferably transparent or translucent in the case of the metal foil used to function as a reflective layer.

The buffer layer 14 is preferably at least one selected from the group consisting of a conductive amorphous carbon film, a conductive oxide film, a magnesium alloy film, and a fluoride film, and may be selected appropriately depending on applications such as an anode or a cathode of the electronic device and required performances.

The usable conductive amorphous carbon film may include a variety of amorphous carbon films having electrical conductivity provided by regulating the concentrations of hydrogen and/or impurities. The conductive amorphous carbon film is preferably formed by sputtering. A carbon target should preferably be purified before the sputtering. Porous carbon impregnated with B, Si, Al and/or Cu may also be used. If the conductive amorphous carbon film is used as the buffer layer, any of an aluminum film, an aluminum alloy film, a silver film, and a silver alloy film may be suitably used for the reflective layer. Aluminum alloys are preferred in consideration of smoothness and material cost.

A preferred conductive amorphous carbon film is composed of a conductive amorphous carbon having a hydrogen content of 15 at% or less. The hydrogen content is more preferably 12 at% or less and further preferably 5 at% or less. Although the lower limit of the hydrogen content is not particularly limited, in other words, may be 0 (zero), the lower limit may be 3 at% in consideration of unavoidable contamination with hydrogen from deposition environment during sputtering. The hydrogen content in the buffer layer may be measured by various known methods, among which hydrogen forward scattering (HFS) is preferred. The hydrogen content in the conductive amorphous carbon film is determined through a measurement of the amounts of carbon and hydrogen by a method such as HFS provided that the total amount of these atoms is 100 at%. Thus significantly low hydrogen content can prevent a decrease in electrical conductivity or a development of insulation properties, which is caused by the termination of carbon atoms constituting the buffer layer with hydrogen atoms, to provide a buffer layer with a high electrical conductivity required for an electrode. It is therefore preferred that the conductive amorphous carbon is not substantially doped with impurities other than carbon and hydrogen. The phrase "not substantially doped" means that impurities for providing a certain function are not intentionally added, allowing for unintentional impurities unavoidably incorporated from the environment such as deposition environment during sputtering. In this respect, the conductive amorphous carbon in the present invention preferably has an oxygen content of 0 wtppm to 300 wtppm, a halogen content of from 0 wtppm to 1,000 wtppm, and a nitrogen content of from 0 wtppm to 500 wtppm. The buffer layer 14 may have any thickness, preferably from 3 nm to 30 nm, more preferably from 3 nm to 15 nm, and further preferably from 5 nm to 10 nm.

A preferred conductive oxide film may be composed of one or more metal oxides selected from the group consisting of InOx, SnOx, ZnOx, MoOₓ, GaOx, VOₓ, WOₓ, RuOx, AlOₓ, TiOₓ, and GeOₓ. Typical examples thereof include indium tin oxide (ITO) and indium zinc oxide (IZO). The conductive oxide film may be formed by a known technique, such as sputtering and vacuum deposition, preferably DC magnetron sputtering. The target material used for sputtering may be prepared by hot pressing or cold pressing, so that the oxides described above may be combined as needed to achieve desired characteristics. In the case where the conductive oxide film is used as the buffer layer, Al-Ni alloys, Ag, and Ag alloy are particularly suitable for the reflective layer.

A preferred magnesium alloy film may be composed of an alloy comprising Mg and one or more additives selected from the group consisting of Ag, Al, Zn, Li, Y, and Ca. The magnesium alloy film may be formed by a known technique, for example, by sputtering or vacuum deposition, preferably vacuum deposition.

A preferred fluoride film may be composed of one or more compounds selected from the group consisting of LiF, MgF₂, CaF₂, AlF₃, Na₃AlF₆, and NaF₆. The fluoride film may be formed by a known technique, for example, sputtering or vacuum deposition, preferably vacuum deposition.

The surface 14a of the buffer layer 14 has an arithmetic mean roughness Ra of 30.0 nm or less, preferably 20.0 nm or less, more preferably 10.0 nm or less, still more preferably 7.0 nm or less, particularly preferably 5.0 nm or less, 3.0 nm or less, 2.8 nm or less, 2.5 nm or less, or 2.0 nm or less. As described above, in the electrode foil of the present invention, the buffer layer formed on the ultra-smooth surface of the reflective layer, of which the ultra-smoothness arises from the ultra-smooth metal foil, can also has a highly smooth surface having a small arithmetic mean roughness Ra. This can reduce the risk of short circuit between the semiconductor functional layers such as the organic EL layers, which is caused by occurrence of excess unevenness. Since the hole injection layer and the hole transport layer or the electron injection layer and the electron transport layer may be thin in organic EL elements without being affected by the surface unevenness of the reflective layer, these layers and an organic EL layer including these layers can be made thinner than conventional thicknesses. As a result, the amount of significantly expensive organic raw materials to be used can be reduced, thereby achieving lower production costs and increased light-emitting efficiency due to the thinned organic EL layer. Such advantages derived from thinned layers in the organic EL element can also be similarly applied to electronic devices in general.

An oxide film (not shown in the drawing) may exist between the reflective layer 13 and the buffer layer 14. The oxide film may be formed typically by spontaneous oxidization of the anode layer by atmospheric oxygen. The oxide film is preferably as thin as possible, for example, with a thickness of preferably 3.0 nm or less, more preferably 1.5 nm or less. The oxide film may be removed, for example, by etching

The electrode foil of the present invention has a thickness of from 1 µm to 300 µm, preferably from 1 µm to 250 µm, more preferably from 5 µm to 200 µm, still more preferably from 10 µm to 150 µm, most preferably from 15 µm to 100 µm. The thickness can be appropriately determined according to the applications or the characteristics required for the electrode foil. Accordingly, if further reduction in the amount of metal or in the weight of the foil is required, the upper limit of the thickness is particularly preferably 50 µm, 35 µm, or 25 µm. If further strength is required, the lower limit of the thickness is particularly preferably 25 µm, 35 µm, or 50 µm. These electrode foils each have a thickness substantially the same as that of the metal foil 12. This is because the thickness of the reflective layer 13 and/or the buffer layer 14 which may be formed on the metal foil 12 is negligibly small compared with the thickness of the metal foil 12.

The electrode foil of the present invention may have any length, and should preferably have a length enough to be applicable to a roll-to-roll process. The length of the electrode foil, which differs depending on the specifications of the device, for example, is preferably at least about 2 m, more preferably at least 100 m, and most preferably at least 1000 m from the viewpoint of productivity. In order to prevent troubles such as winding displacement and winding wrinkles, such a long metal foil should be wound under a high tension of 5 to 100 kgf/100 mm width; however, this process readily causes winding defects due to contact between the inner and outer surfaces. In contrast, the electrode foil of the present invention has significantly smoothed outer and inner surfaces, which can effectively prevent winding defects. Although it is an effective measure against winding defects to provide more resilient material than the electrode foil, such as a film or embossed film interposed between the outer and inner surfaces, an additional winding-up process of the interposed material is necessary prior to the subsequent process, which complicates the process. The electrode foil of the present invention, which can prevent winding defects without such interposed material, is advantageous in this respect.

The electrode foil of the present invention can be preferably used as an electrode (i.e., anode or cathode) for various electronic devices. The electrode foil of the present invention, which can be readily bent at low stress, is particularly preferably used as an electrode for flexible electronic devices, and it may also be used for less flexible or more rigid electronic devices. As described above, the surfaces on both sides of the electrode foil of the present invention are so significantly smooth that the top surfaces on the both sides of an electrode foil are highly advantageous to dispose the electronic devices thereon, thereby providing a double-sided functional element or a double-sided functional element foil having the electronic devices on the both sides thereof. Examples of the electronic devices (mainly flexible electronic devices) include i) light-emitting elements (e.g., an organic EL element, an organic EL lighting device, an organic EL display, an electronic paper display, a liquid crystal display, an inorganic EL element, an inorganic EL display, LED lighting device, and LED display; ii) photoelectric elements (e.g., a thin film solar cell), iii) thermoelectric elements; preferably an organic EL element, an organic EL lighting device, an organic EL display, an organic solar cell, a dye-sensitized solar cell, and a thermoelectric element, and more preferably an organic EL lighting device because it is significantly thin and emits light of high luminance. The electrode foil of the present invention can be preferably used for an anode or a cathode of the organic solar cell because many characteristics required for the electrode of the organic solar cell are in common with those of the organic EL element. Accordingly, appropriate selection of the type of an organic semiconductor functional layer to be laminated on the electrode foil of the present invention in accordance with known techniques allows construction of any one of the organic EL element and the organic solar cell. Furthermore, the present invention enables formation of a light-emitting element on one side and a power-generating element on the other side of the same electrode, which configuration provides a novel composite electronic device that has combined functions of the organic EL element and the organic solar cells. Furthermore, the electrode foil of the present invention can be used for not only the electrode of the organic EL element, but also a mounting substrate for the LED. In particular, the electrode foil of the present invention can be preferably used for an anode or a cathode for the LED lighting device since the LED elements can be densely mounted thereon.

### Electronic device

The electrode foil of the present invention can provide an electronic device comprising a semiconductor functional layer having semiconductor functional properties provided directly on at least one of the outermost surfaces of the electrode foil, and preferably comprising semiconductor functional layers provided directly on the outermost surfaces on both sides of the electrode foil because of the ultra-smoothness of the surfaces. The semiconductor functional layer may be of any material and structure having semiconductor characteristics that can express the desired functions on an electrode or between the electrodes. An organic semiconductor, an inorganic semiconductor, or mixtures or combinations thereof are preferred. For example, the semiconductor functional layer preferably has at least one function selected from the group consisting of photoexcited power generation, thermally excited power generation, and excited luminescence. Furthermore, the light-emitting element and the photoelectric element are preferably provided with a transparent or translucent counter electrode on the semiconductor functional layer. The process of dissolving polymer materials and low molecular materials in such a solvent as chlorobenzene and applying the solution is preferably applicable to the process of forming the semiconductor functional layer on the electrode foil of the invention, and an in-line vacuum process, which is suitable for improving productivity, is also applicable.

In a preferred embodiment of the present invention, the semiconductor functional layers are provided directly on the outermost surfaces on both sides of the electrode foil such that both the semiconductor functional layers have the same functions. The structure of the electrode foil having the same functions on its both sides can be expected to exhibit a significantly improved functionality compared with the structure having the functions on the only one surface, resulting in a light emission in all directions in the light-emitting element and a higher voltage in the thermoelectric element and the photoelectric element.

In another preferred embodiment of the present invention, semiconductor functional layers are provided directly on the outermost surfaces on both sides of the electrode foil, and these semiconductor functional layers may have mutually different functions. Such a structure of the electrode foil with the surfaces having different functions enables fabrication of an element provided with a front side and back side (e.g., an indoor side and outdoor side) having functions different from each other. For example, formation of a light-emitting element on one side and a power-generating element on the other side of the same electrode provides a novel composite electronic device having combined functions of the organic EL element and the organic solar cell.

(1) Double-sided organic EL element and double-sided organic EL lighting device A double-sided light-emitting element and a double-sided organic EL lighting device which are provided with a top-emission organic EL element on both sides can be constructed with the electrode foil of the present invention as a reflective electrode.

Fig. 2 shows an example layer structure of a top-emission EL element that includes the electrode foil of the present invention as an anode. The organic EL element depicted in Fig. 2 comprises an anodic electrode foil 20 comprising a metal foil 22, reflective layers 23,23 and optionally buffer layers 24,24; organic EL layers 26,26 provided directly on the buffer layers; and cathodes 28,28 as light-transmitting electrodes provided directly on the organic EL layers. The buffer layer 24 is preferably composed of a conductive amorphous carbon film or a conductive oxide film suitable for an anode.

The organic EL layer 26 may have various known EL layer structures used for organic EL elements and may comprise optionally a hole injection layer and/or a hole transport layer, a light-emitting layer, and optionally an electron transport layer and/or an electron injection layer in this order from the anodic electrode foil 20 to the cathode 28. Any known structure or composition may be appropriately applied to each of the hole injection layer, the hole transport layer, the light-emitting layer, the electron transport layer, and the electron injection layer, without any particular limitation.

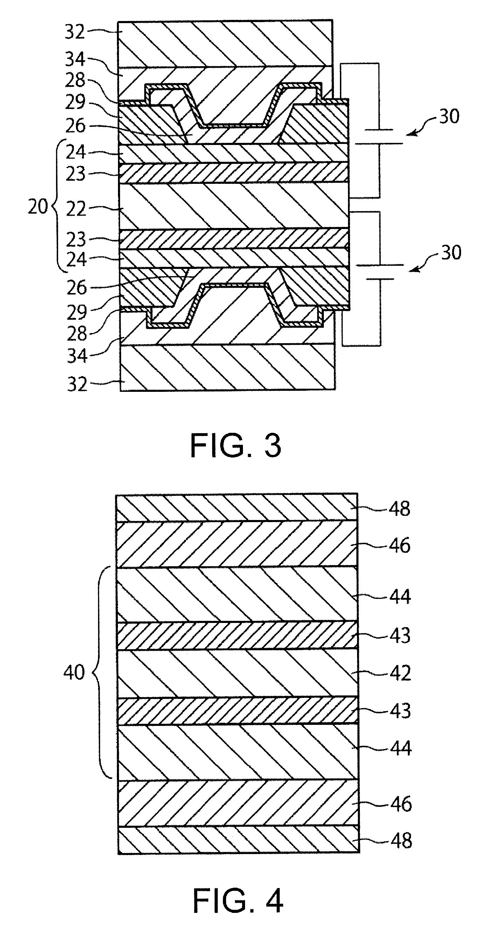

Fig. 3 illustrates an example layer structure of a top-emission organic EL lighting device incorporating organic EL elements depicted in Fig. 2 on both sides thereof. In the organic EL lighting device depicted in Fig. 3, the organic EL element is electrically connectable with a power source 30 through the metal foil 22 of the anodic electrode foil 20. The surface area, not in contact with the organic EL layer 26, of the buffer layer 24 is covered with an interlayer insulating film 29. The interlayer insulating film 29 is preferably a Si-based insulating film, more preferably a SiN-based insulating film formed by CVD, which exhibits high barrier properties against water and oxygen that cause degradation of organic layers. A more preferred film is a SiNO-based insulating film, which has small internal stress and high flexibility.

Sealing materials 32,32 are disposed above and below the cathodes 28,28, respectively, of the organic EL element. The gap between the sealing material 32 and the organic EL element 20 is filled with a sealing resin to form a sealing film 34. The sealing material 32 may be composed of a glass sheet or a film. In the case of a glass sheet, the sealing material 32 may be bonded directly onto the sealing film 34 using a hydrophobic adhesive tape. In the case of a film, both surfaces and end faces thereof may be covered with a Si-based insulating film. If a film having high barrier properties is developed in future, sealing suitable for mass production would be possible without such preliminary coating treatment. Although films having high flexibility are preferable as the sealing material 32, the required performance can be achieved with a sealing material formed of a film bonded to a significantly thin glass sheet having a thickness of 20 µm to 100 µm.

The cathode 28 may be composed of any of known transparent or translucent materials used in top-emission organic EL elements requiring light transmission. Materials having low work functions are preferred. Examples of the material for preferable cathodes include conductive oxide films, magnesium alloy films, and fluoride films. A combination of two or more materials is more preferred. The usable films are similar to those described for the buffer layer of the electrode foil.

A particularly preferable cathode has a double-layer laminated structure including a translucent metal layer as a buffer layer composed of a magnesium alloy film and/or a fluoride film and a transparent oxide layer as a cathode layer composed of a conductive oxide film. This structure is highly useful in terms of resistance characteristics. In this case, a high optical transparency and a low work function can be provided by bringing the translucent metal layer (buffer layer) of the cathode 28 into contact with the organic EL layer 26, resulting in enhanced brightness and power efficiency of the organic EL element. The most preferred example is a laminated cathode structure of a transparent oxide layer (cathode layer) composed of indium zinc oxide (IZO) and a translucent metal layer (buffer layer) composed of Mg-Ag. Furthermore, the cathode structure may have two or more transparent oxide layers and/or two or more translucent metal layers. Thus, the light generated in the organic EL layer 26 passes through the cathode 28, the sealing film 34, and then the sealing material 32 to be emitted to the outside.

Fig. 4 illustrates an example layer structure of a top-emission organic EL element including the electrode foil of the present invention as a cathode. The organic EL element depicted in Fig. 4 includes a cathodic electrode foil 40 comprising a metal foil 42, reflective layers 43,43 and buffer layers 44; 44; organic EL layers 46,46 provided directly on the buffer layers; and anodes 48,48 as counter electrodes provided directly on the organic EL layers. The organic EL layer 46 may have a configuration similar to the organic EL layer 26 depicted in Fig. 2. The buffer layer 44 may also have a configuration similar to the cathode 28 depicted in Fig. 2, and preferably composed of a conductive oxide film, a magnesium alloy film, a fluoride film, or a combination of two or more thereof. More preferably, the buffer layer 44 is a translucent metal layer composed of a magnesium alloy film and/or a fluoride film.

More specifically, the organic EL element including the cathodic electrode foil 40 depicted in Fig. 4 corresponds to a structure of the organic EL element including the anodic electrode foil 20 depicted in Fig. 2, except that the buffer layers 24 and the cathodes 28 are interchanged, respectively, and the order of the layers from the anodes inside the organic EL layer 26 to the cathodes is inverted. In a preferred embodiment, a magnesium alloy film or a fluoride film as the buffer layer 44 of the cathodic electrode foil 40 is formed by sputtering or vapor deposition while a film composed of conductive amorphous carbon, MoO₃, or V₂O₅ as the anode 48 is formed by vapor deposition. In particular, a conductive amorphous carbon film is preferably formed on the organic EL layer by vacuum deposition to avoid plasma damaging during sputtering.

### (2) Double-sided photoelectric element

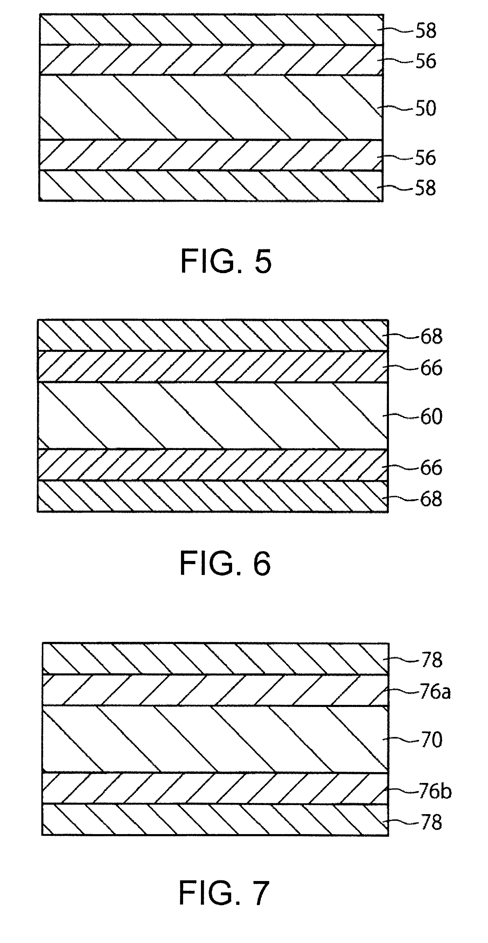

As depicted in Fig. 5, thermoelectric elements may be formed on both sides of the electrode foil of the present invention as a reflective electrode. The photoelectric element depicted in Fig. 5 includes an electrode foil 50, photoexcitation layers 56,56 as semiconductor functional layers provided directly on the surfaces of the electrode foil, and light-transmitting counter electrodes 58. 58 provided directly on the surfaces of the photoexcitation layers. The photoexcitation layer 56 may have various structures and may be composed of materials which are known as semiconductor functional layers of photoelectric elements.

For example, the organic EL layer 26 depicted in Fig. 2 may be replaced with a known organic solar cell active layer to construct an organic solar cell. The organic solar cell including the electrode foil of the present invention as an anode can be disposed on a buffer layer (e.g., a carbon buffer layer) by depositing a hole transport layer (PEDOT:PSS (30 nm)), a p-type organic semiconductor layer (e.g., BP (benzoporphyrin)), an i-type mixing layer (e.g., BP:PCBNB (fullerene derivative) of an n-type organic semiconductor and a p-type organic semiconductor, an n-type organic semiconductor layer (e.g., PCBM (fullerene derivative)), a buffer layer having a low work function (e.g., Mg-Ag), and a transparent electrode layer (e.g., IZO) in this order. Known materials may be appropriately used for these layers without any particular limitation. The electrode used for organic solar cells may be composed of the same materials and may have the same structures as an electrode used for organic EL elements. The electrode foil of the present invention comprises a reflective layer, which will increase the power generation efficiency by light confinement due to cavity effect.

### (3) Double-sided thermoelectric element

As depicted in Fig. 6, thermoelectric elements may be disposed on both sides of the electrode foil of the present invention used as a reflective electrode. The thermoelectric element depicted in Fig. 6 includes an electrode foil 60, thermoexcitation layers 66,66 as semiconductor layers provided directly on the surfaces of the electrode foil, and counter electrodes 68,68 (e.g., copper foil) provided directly on the thermoexcitation layers. The thermoexcitation layers 66 are each preferably composed of a combination of an n-type semiconductor functional layer and a p-type semiconductor functional layer. For example, in Fig. 6, the double-sided thermoelectric elements may comprise an upper counter electrode 68, an n-type semiconductor functional layer, a p-type semiconductor functional layer, an electrode foil 60, an n-type semiconductor functional layer, a p-type semiconductor functional layer, and a lower counter electrode 68 in this order, or an upper counter electrode 68, a p-type semiconductor functional layer, an n-type semiconductor functional layer, an electrode foil 60, an n-type semiconductor functional layer, a p-type semiconductor functional layer, and a lower counter electrode 68 in this order. In these structures, the p-type semiconductor functional layer and the n-type semiconductor functional layer are interchangeable.

Examples of the conductive polymer used in the thermal excitation layer 66 include polyacetylene, polyphenylene, polypyrrole, polythiophene, polyfuran, polyselenophene, polyisothianaphthene, polyphenylene sulfide, polyaniline, polyphenylenevinylene, polythiophenevinylene, polyperinaphthalene, polyanthracene, polynaphthalene, polypyrene, polyazulene, and derivatives, copolymers (binary or ternary copolymers), and mixtures thereof. The more preferred conductive polymer includes polypyrrole, polythiophene, polyaniline, and derivatives and copolymers (binary or ternary copolymer) thereof. Combination of appropriately selected p-type and n-type compounds from these compounds enables the construction of the thermal excitation layer 66.

### (4) Hybrid electrooptic and optoelectric element

As depicted in Fig. 7, a light-emitting element and a photoelectric element may be provided on a first side and a second side, respectively, of the electrode foil of the present invention used as a reflective electrode. The hybrid electrooptic and optoelectric element as depicted in Fig. 7 includes an electrode foil 70, a light-emitting layer 76a as a semiconductor functional layer provided directly on one surface of the electrode foil, and a light-transmitting electrode 78 as a counter electrode provided directly on the surface of the light-emitting layer, while the hybrid element includes a photoexcitation layer 76b as a semiconductor functional layer provided directly on the other surface of the electrode foil, and a light-transmitting electrode 78 as a counter electrode provided directly on the surface of the photoexcitation layer. The light-emitting layer 76a may be constructed in a manner similar to organic EL layers 26,46 depicted in Figs. 2 to 4, and the photoexcitation later 76b may be constructed in a manner similar to the photoexcitation layer 56 depicted in Fig. 5.

### EXAMPLES

The present invention will be further described in detail with reference to the following examples.

### Example 1: Preparation of ITO/Al-alloy/Cu/Al-allov/ITO electrode foil

As metal foil, 64-µm thick commercially available electrolytic copper foil (DFF (Dual Flat Foil), manufactured by Mitsui Mining & Smelting Co., Ltd.) was prepared. The surface roughness of the copper foil was measured with a scanning probe microscope (Nano Scope V, manufactured by Veeco Instrument Inc.) in accordance with JIS B0601-2001. The arithmetic mean roughness Ra was 12.20 nm on the front surface and 248 nm on the back surface. This measurement was performed in an area of 10 µm square with a Tapping Mode AFM.

One surface of the copper foil was subjected to chemical mechanical polishing (CMP) treatment with a polishing machine manufactured by MAT Inc. This CMP treatment was performed with a polishing pad having XY grooves and a colloidal silica polishing solution under the conditions of a pad rotation speed of 30 rpm; a load of 200 gf/cm², and a liquid supply rate of 100 cc/min. The other surface of the copper foil was also subjected to CMP similarly. The surface roughness of the copper foil after the CMP treatment was measured with the scanning probe microscope (Nano Scope V, manufactured by Veeco Instruments Inc.) in accordance with JIS B 0601-2001. The arithmetic mean roughness Ra was 0.7 nm on both surfaces. This measurement was performed in an area of 10 µm square with a Tapping Mode AFM. The thickness of the copper foil after the CMP treatment was 61 µm.

An Al alloy reflective layer with a thickness of 150 nm was deposited on one surface of the copper foil treated with CMP by sputtering. An aluminum alloy target (203.2 mm diameter and 8 mm thick) having a composition of Al-0.2B-3.2Ni (at%) was placed in a magnetron sputtering apparatus (MSL-464, manufactured by Tokki Corp.) provided with a cryopump, and then the sputtering was performed under the conditions of an input power (DC) of 1,000 W (3.1 W/cm²); an ultimate vacuum of lower than 5x10⁻⁵ Pa; a sputtering pressure of 0.5 Pa; an Ar flow of 100 sccm; and a room substrate temperature.

An ITO buffer layer with a thickness of 10 nm was deposited by sputtering on the surface of the resulting aluminum alloy reflective layer. An ITO (In₂O₃-SnO₂) target (203.2 mm diameter and 6 mm thick) containing 10 wt% of Sn was placed in a magnetron sputtering apparatus (MSL-464, manufactured by Tokki Corp.) provided with a cryopump and then this sputtering was performed under the conditions of a input power (DC) of 300 W (0.9 W/cm²); an ultimate vacuum of lower than 5x10⁻⁵ Pa; a sputtering pressure of 0.35 Pa; an Ar flow of 80 sccm; an O₂ flow of 1.9 sccm; and a room substrate temperature. The thickness of the film was controlled by the adjustment of the discharging time. The surface roughness of the resulting buffer layer was measured in the same manner as mentioned above. The arithmetic mean roughness Ra was 2.0 nm. The reflective layer and the buffer layer were prepared on the other side of the copper foil similarly. The total thickness of the resulting electrode foil was 62 µm.

### Example 2: Fabrication of double-sided organic EL element

The electrode foil (ITO/Al-alloy/Cu/Al-alloy/ITO) prepared in Example 1 was used as an anode to prepare organic EL elements having a structure as depicted in Figs. 2 and 4. A glass plate (3 cm square and 0.5 mm thick) as a mask was placed on one side of the electrode foil 20 (5 cm square), and then an interlayer insulating film 29 composed of silicon nitride was deposited thereon by plasma-enhanced chemical vapor deposition (CVD). This plasma-enhanced CVD was performed under the conditions of an effective film forming area with a diameter of eight inches; an input power (RF) of 250 W (0.8 W/cm²); an ultimate vacuum pressure of lower than 5x10⁻³ Pa; a sputtering pressure of 80 Pa; a gas flow of SiH₄ (diluted with H₂ to 10%):NH₃:N₂ = 100:10:200 sccm; and a substrate temperature at 250°C, using a plasma-enhanced CVD apparatus (PD-2202L, manufactured by Samco Inc.) provided with a mechanical booster pump (MBP) and a rotary pump (RP). The glass was then removed from the electrode foil 20 to obtain an interlayer insulating film 29 having an opening of 3 cm square on the electrode foil.

The surface of the electrode foil having the interlayer insulating film was washed as follows. Ultrasonic washing for 3 minutes was performed twice in a bath filled with an ultrapure water (resistance > 18.0 MΩ), which was replaced with a fresh one for the second washing. After water was thoroughly removed with nitrogen gas, the film was post-cured at 100°C for 3 hours. The resulting surface was cleaned by UV irradiation.

An organic EL layer 26, a cathode 28, a sealing layer 34, and a sealing material 32 were deposited on the washed electrode foil. Specifically, a 50-nm thick hole injection layer composed of copper phthalocyanine, a 40-nm thick hole transport layer composed of 4,4'-bis(N,N'-(3-tolyl)amino)-3,3'-dimethylbiphenyl (HMTPD), a 30-nm thick light-emitting layer composed of a host material doped with tris(2-phenylpyridine) iridium complex (Ir(ppy)₃), a 30-nm thick electron transport layer composed of Alq3, a 10-nm thick translucent layer composed of Mg-Ag (Mg:Ag=9:1), a 100-nm thick transparent oxide layer composed of In-Zn-O (IZO), a 300-nm thick passivation film (sealing layer) composed of silicon nitride, a 2,000-nm thick adhesive layer, and a 200-µm thick sealing glass (sealing material) were deposited in this order on the buffer layer 24 of the electrode foil 20. The sealing glass was deposited with a double-sided tape. The double-sided tape corresponds to the adhesive layer.

An organic EL element, which has an area of 50 mm square, a thickness of 300 µm, and a light-emitting area of 30 mm square, was thereby prepared on one side of the electrode foil. Similarly, another organic EL element having an area of 50 mm square, a thickness of 300 µm, and a light-emitting area of 30 mm square was prepared on the other side of the electrode foil to fabricate a double-sided organic EL element. That is, organic EL layers 26,26 are disposed symmetrically about the electrode foil 20. When this sample provided with the organic EL elements on both sides was connected to a power source 30 and then loaded with a voltage of 5.0 V, intense light emission was observed from the both sides.

### Example 3: Fabrication of double-sided organic EL element

An Al alloy reflective layer with a thickness of 150 nm was formed by sputtering on a copper foil prepared as in Example 1. An aluminum alloy target (203.2 nm diameter and 8 mm thick) having a composition of Al-4Mg (at%) was placed in a magnetron sputtering device (MSL-464, manufactured by Tokki Corp.) provided with a cryopump, and then the sputtering was performed under the conditions of an input power (DC) of 1,000 W (3.1 W/cm²); an ultimate vacuum of lower than 5x10⁻⁵ Pa; a sputtering pressure of 0.5 Pa; an Ar flow of 100 sccm; and a room substrate temperature. An electrode foil usable as a cathodic electrode in an organic EL element was prepared.

The resulting electrode foil (Cu/Al alloy) was used as a cathode to prepare an organic EL element. A glass plate (3 cm square and 0.5 mm thick) as a mask was placed on the electrode foil (5 cm square), and then an interlayer insulation film composed of silicon nitride was formed by plasma-enhanced chemical vapor deposition (CVD). This plasma-enhanced CVD was performed under the conditions of an effective film forming area with a diameter of eight inches; an input power (RF) of 250 W (0.8 W/cm²); an ultimate vacuum pressure of lower than 5x10⁻³ Pa; a sputtering pressure of 80 Pa; a gas flow of SiH₄ (diluted with H₂ into 10%):NH₃:N₂ = 100:10:200 sccm; and a substrate temperature at 250°C, in a plasma-enhanced CVD device (PD-2202L, manufactured by Samco Inc.) provided with a mechanical booster pump (MBP) and a rotary pump (RP). The glass was then removed from the electrode foil to obtain an interlayer insulating film having an opening of 3 cm square on the electrode foil.

An organic EL layer, an anode, a sealing layer, and a sealing material were deposited on the washed electrode foil. Specifically, a 50-nm-thick α-NPD layer, a 50-nm-thick Alq3 layer, a 20-nm-thick MoO₃ layer, a 100-nm-thick transparent oxide layer composed of In-Zn-O (IZO), a 300-nm-thick passivation film (sealing layer) composed of silicon nitride, a 2,000-nm-thick adhesive layer, and a 200-µm-thick sealing glass (sealing material 132) were deposited in this order on the reflective layer surface of the electrode foil. The sealing glass was deposited with a double-sided tape. The double-sided tape corresponds to the adhesive layer.

An organic EL element, having an area of 50 mm square, a thickness of 300 µm, and a light-emitting area of 30 mm square, was thereby prepared on one surface of the electrode foil. Similarly, another organic EL element having an area of 50 mm square, a thickness of 300 µm, and a light-emitting area of 30 mm square was prepared on the other side of the electrode foil. When this sample provided with the organic EL element on both sides was connected to a power source and then loaded with a voltage of 10 V, a green light emission from Alq3 was observed.

### Example 4: Fabrication of double-sided photoelectric element

The surface roughness of a metal foil, 64 µm thick commercially available electrolytic copper foil (Dual Flat Foil (DFF) having flat faces, manufactured by Mitsui Mining & Smelting Co., Ltd.) was measured with a scanning probe microscope (Nano Scope V, manufactured by Veeco Instrument Inc.) in accordance with JIS B0601-2001. The arithmetic mean roughness Ra was 12.20 nm. The roughness was measured in an area of 10 µm square with a Tapping Mode AFM.

One surface of the copper foil was subjected to chemical mechanical polishing (CMP) treatment with a polishing machine manufactured by MAT Inc. This CMP treatment was performed with a polishing pad having XY grooves and a colloidal silica polishing solution under the conditions of a pad rotation speed of 30 rpm; a load of 200 gf/cm²; and a liquid supply rate of 100 cc/min. The other surface of the copper foil was also subjected to CMP similarly. The surface roughness of the copper foil after the CMP treatment was then measured with the scanning probe microscope (Nano Scope V, manufactured by Veeco Instruments Inc.) in accordance with JIS B 0601-2001. The arithmetic mean roughness Ra was 0.7 nm on both surfaces. The roughness was measured in an area of 10 µm square with a Tapping Mode AFM. The thickness of the copper foil after the CMP treatment was 61 µm.

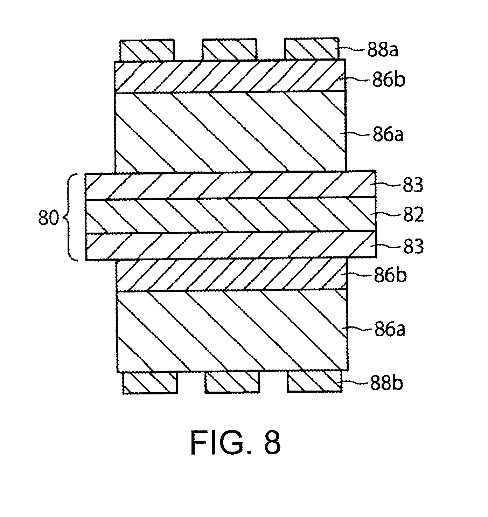

As depicted in Fig. 8, a reflective layer 83 of Al-Ni alloy was formed on one surface of the resulting copper foil 82 by sputtering. An interlayer insulating film composed of silicon nitride was formed on the reflective layer in a plasma-enhanced CVD device (PD-2202L, manufactured by SAMCO Inc.). Thin glass sheets having a thickness of 0.1 mm, a width of 2 mm, and a length of 10 mm were then aligned at 2 mm intervals to mask parts to be used for light receiving sections on the electrode foil. After the deposition of silicon nitride, the glass sheets were removed. The electrode foil 80 was then washed with isopropyl alcohol heated to a temperature in the range of 40°C to 50°C and dried with nitrogen gas. P3HT and PCBM were then added to a chrolobenzene solution each into a concentration of 10 mg/ml, and then kept at about 25°C for 24 hours to be completely dissolved. The mixed solution of P3HT and PCBM in chlorobenzene was applied onto the electrode foil 80 by spin coating at a rotation rate of 1500 rpm, and a P3HT:PCBM layer 86a with a thickness of 100 nm was prepared. A dispersion of poly (3,4-ethylenedioxythiophene)/poly (4-styrenesulfonic acid) (PEDOT:PSS) (1.3 % by weight) was then applied onto the electrode foil by spin coating at a rotation rate of 5000 rpm. The applied electrode was dried on a hot plate at 180°C for 30 minutes to prepare a PEDOT:PSS layer 86b. Gold was deposited into a thickness of about 100 nm in a vacuum deposition device to prepare a counter electrode 88a. Parts to be used for light receiving sections were masked with a comb-shaped metal mask to avoid blocking light. Then, the sample was heated at 150°C for 30 minutes in an inert atmosphere (nitrogen).

Layers were stacked on the other surface of the electrode foil 80 in the reverse order of the element prepared on the one surface. That is, a PEDOT:PSS layer 86b was first formed on the electrode foil 80 and then a P3HT:PCBM layer 86a was provided as a power-generating layer, followed by annealing. Finally, an aluminum film 88b was formed by vacuum deposition through the comb-shaped metal mask. The resulting double-sided photoelectric element can provide 1.5 times as much potential difference between the gold electrode and the aluminum electrode as the single layer photoelectric element.

## Claims

1. An electrode foil comprising a metal foil, wherein the metal foil has a thickness of 1 to 250 µm, and wherein the outermost surfaces on both sides of the electrode foil are ultra-smooth surfaces each having an arithmetic mean roughness Ra of 30.0 nm or less as determined in accordance with JIS B 0601-2001.

2. The electrode foil according to claim 1, wherein the arithmetic mean roughness Ra is 10.0 nm or less.

3. The electrode foil according to claim 1 or 2, wherein the electrode foil is used as an electrode functioning as a supporting substrate for a flexible electronic device.

4. The electrode foil according to any one of claims 1 to 3, wherein the electrode foil is used as an electrode functioning as a supporting substrate for an electronic device having functionality on both sides.

5. The electrode foil according to any one of claims 1 to 4, wherein the electrode foil is used as an electrode for at least one selected from the group consisting of a light-emitting element, a photoelectric element, and a thermoelectric element.

6. The electrode foil according to any one of claims 1 to 5, wherein the metal foil has a thickness of 10 µm to 150 µm.

7. The electrode foil according to any one of claims 1 to 6, wherein the metal foil has a thickness of 1 µm to 50 µm.

8. The electrode foil according to any one of claims 1 to 7, wherein the metal foil is a nonmagnetic metal foil.

9. The electrode foil according to any one of claims 1 to 8, wherein the metal foil is a copper foil.

10. The electrode foil according to any one of claims 1 to 9, further comprising one or two reflective layers provided directly on one or two surfaces of the metal foil, wherein the outer surfaces of the reflective layers constitute the respective ultra-smooth surfaces.

11. The electrode foil according to any one of claims 1 to 9, further comprising one or two transparent or translucent buffer layers provided directly on one or two surfaces of the metal foil, wherein the outer surfaces of the buffer layers constitute the respective ultra-smooth surfaces.

12. The electrode foil according to any one of claims 1 to 9, further comprising one or two reflective layers provided directly on one or two surfaces of the metal foil and one or two transparent or translucent buffer layers provided directly on one or two surfaces of the reflective layers, wherein the outer surfaces of the buffer layers constitute the respective ultra-smooth surfaces.

13. The electrode foil according to any one of claims 1 to 12, wherein the electrode foil has a thickness of 1 µm to 300 µm.

14. A copper foil having a thickness of 1 µm to 150 µm, wherein the surfaces on both sides of the copper foil each have an arithmetic mean roughness Ra of 10.0 nm or less as determined in accordance with JIS B 0601-2001.

15. An electronic device comprising:
the electrode foil according to any one of claims 1 to 13; and
at least one semiconductor functional layer having semiconductor characteristics provided directly on at least one outermost surface of the electrode foil.

16. The electronic device according to claim 15, wherein the semiconductor functional layers are provided directly on the outermost surfaces on both sides of the electrode foil and have the same or different functions from each other.

17. The electronic device according to claims 15 or 16, wherein the semiconductor functional layer comprises an organic semiconductor; an inorganic semiconductor; or mixtures or combinations thereof.

18. The electronic device according to any one of claims 15 to 17, wherein the semiconductor functional layer has at least one function selected from the group consisting of photoexcited power generation, thermally excited power generation, and excited luminescence.

19. The electronic device according to any one of claims 15 to 18, comprising a transparent or translucent counter electrode on the semiconductor functional layer.
